# FASCICULE DE BREVET EUROPEEN

(11) **EP 0 553 029 B1**
(45) Date de publication et mention de la délivrance du brevet: **24.09.1997**
(21) Numéro de dépôt: 93400142.1
(22) Date de dépôt: 21.01.1993
(51) Int. Cl.: H04B 10/24, H04B 10/06

(54) **Photorécepteur pour signaux optiques modulés en fréquence, émetteur-récepteur et liaison optique correspondants**
Photoempfänger für frequenzmodulierte optische Signale, entsprechende Sender-Empfänger und optische Verbindung
Photoreceiver for frequency modulated optical signals, corresponding transmitter-receiver and optical link

(30) Priorité: 24.01.1992 FR 9200753
(43) Date de publication de la demande: 28.07.1993
(73) Titulaire: FRANCE TELECOM, 75015 Paris (FR)
(72) Inventeur: Nakajima, Hisao, 92220 Bagneux (FR); Derouiche, Radhouane, F-75015 Paris (FR)
(74) Mandataire: Signore, Robert

(56) Documents cités:
- EP-A- 0 420 742
- FR-A- 2 662 883
- PATENT ABSTRACTS OF JAPAN vol. 13, no. 476 (E-837)1989 & JP-A-11 87 889
- PATENT ABSTRACTS OF JAPAN vol. 15, no. 470 (E-1139)1991 & JP-A-32 03 268

## Description

### Domaine technique

La présente invention a pour objet un photorécepteur pour signaux optiques modulés en fréquence, un émetteur-récepteur correspondant et une liaison optique bidirectionnelle utilisant un tel émetteur-récepteur.

L'invention trouve des applications générales en télécommunications optiques.

### Etat de la technique antérieure

Dans le domaine des télécommunications optiques, il est fait usage depuis quelques années de dispositifs à semiconducteurs particulièrement avantageux puisqu'ils se comportent aussi bien en émetteur qu'en récepteur.

De tels dispositifs sont décrits notamment dans les articles suivants :
- A. Alping, B. Bentland et S.T. Eng, "100 Mb/s laser diode terminal with optical gain for fibre-optic local area networks", Electron. Lett., 20, pp. 794-795 (1984),
- N.A. Olsson et L.L. Buhl, "Single-laser high-selectivity bidirectional transmission system for local-area-network applications", Electron. Lett., 23, pp. 62-64 (1987),
- L. d'Auria, G. Chevalier et P. Maillot, "LIBIDO using EROS half-duplex optical kink", Electron. Lett., 15, pp. 820-821, (1979),
- P.A. Andrekson et N.A. Olsson, "Optical full-duplex transmission with diode laser amplifiers", J. Light-wave Tech., 9, pp. 737-740, (1991).

Des liaisons optiques travaillant en modulation de fréquence (FM) ou en décalage de fréquence ("Frequency Shift Keying" ou FSK) ont pu être ainsi réalisées avec un laser à semiconducteur travaillant en émetteur et en récepteur. De telles liaisons ont été décrites par exemple dans les documents suivants :
- T.L. Koch, F.S. Choa, F. Heisman et U. Koren, "Tunable multiple-quantum-well distributed-Bragg-reflector laser as tunable narrowband receivers", Electron. Lett., 25, pp. 890-892, (1989),
- M.J. Chawki, R. Auffret et L. Berthou, "1.5 Gb/s FSK transmission system using two electrode DFB laser as tunable FSK discriminator/photodetector", Electron. Lett., 26, pp. 1146-1148 (1990),
- H. Nakajima, "Demodulation of multi-gigahertz frequency-modulated optical signals in an injection-locked distributed feedback laser oscillator", Electron. Lett., 26, pp. 1129-1130 (1990),
- FR-A-2 652 465.

Dans cette technique connue, la structure semiconductrice est généralement une structure à contre-réaction distribuée ("Distributed Feedback" ou DFB en abrégé). Deux types de fonctionnement peuvent se présenter selon que la structure fonctionne en amplificateur (c'est le cas lorsqu'elle est polarisée en dessous du seuil) ou en oscillateur (lorsqu'elle est polarisée largement au-dessus du seuil).

Dans tous les cas, on prélève la tension aux bornes de la structure semiconductrice, les variations de cette tension traduisant les variations de fréquence. On peut donc effectuer, par le biais de cette tension, une démodulation restituant l'information d'origine ayant servi à moduler le faisceau optique (en FM ou en FSK).

Le dernier document cité, à savoir FR-A-2 652 465, décrit notamment les différences entre les deux régimes de fonctionnement (amplificateur, oscillateur) et montre, entre autres, l'intérêt des structures fonctionnant en oscillateur.

Bien que donnant satisfaction à certains égards, ces dispositifs présentent l'inconvénient de ne présenter qu'une sensibilité limitée dans la conversion fréquence-tension. Dans le régime amplificateur, la sensibilité de conversion est de l'ordre de 0,6 mV/GHz. Dans le régime oscillateur, elle est encore plus faible et tombe à 0,2 mV/GHz. Cette faible sensibilité limite le débit de transmission.

La présente invention a justement pour but de remédier à cet inconvénient en proposant une structure conduisant à une meilleure efficacité. Selon l'invention, la sensibilité passe à environ 1,2 mV/GHz soit le double de l'efficacité des meilleurs dispositifs antérieurs. Cette amélioration est valable aussi bien en régime amplificateur qu'en régime oscillateur.

### Exposé de L'invention

L'invention propose d'utiliser encore une structure du type à contre-réaction distribuée (DFB) mais dans le cas où cette structure comprend une zone de déphasage optique dans le réseau. On sait qu'une telle zone, appelée parfois "déphaseur", permet de supprimer une dégénérescence en longueur d'onde perturbant le fonctionnement du laser en ce sens qu'elle rend possible l'oscillation sur deux longueurs d'onde différentes. Grâce à l'introduction d'un déphaseur, une seule longueur d'onde devient possible. L'invention fait usage-de ce perfectionnement et propose de placer une électrode réservée au prélèvement de la tension au-dessus du déphaseur, l'électrode d'alimentation de la structure étant maintenue mais divisée en deux demi-électrodes, disposées de part et d'autre de l'électrode de prélèvement.

De façon précise, la présente invention a donc pour objet un photorécepteur pour signaux optiques modulés en fréquence, comprenant une structure semiconductrice à contre-réaction distribuée (DFB) composée d'un empilement de couches dont une couche active et un réseau de diffraction optiquement couplé à au moins une partie de la couche active, ce réseau comportant une région centrale introduisant un déphasage optique, cette structure étant recouverte d'une électrode reliée à une source de courant, ce photorécepteur comprenant en outre des moyens pour r prélever la tension aux bornes de la structure, ce photorécepteur étant caractérisé par le fait que les moyens pour prélever la tension aux bornes de la structure sont constitués par une électrode centrale disposée au-dessus de la région centrale du réseau introduisant un déphasage optique, L'électrode d'alimentation étant alors divisée en deux demi-électrodes latérales disposées de part et d'autre de l'électrode centrale et électriquement isolées de celle-ci.

La présente invention a également pour objet un émetteur-récepteur qui est constitué par le photorécepteur qui vient d'être défini, celui-ci étant utilisé en outre comme source laser.

On peut observer que le composant de l'invention travaille dans la zone de verrouillage, c'est-à-dire que le rayonnement émis est verrouillé en fréquence sur le rayonnement reçu.

Enfin, l'invention a pour objet une liaison optique bidirectionnelle qui comprend deux ensembles émetteur-récepteur constitués par l'émetteur-récepteur précédent, lequel travaille toujours dans la zone de verrouillage.

### Brève description des dessins

- la figure 1 illustre un photorécepteur selon l'invention ;
- la figure 2 montre les variations de la puissance optique le long de la couche active ;
- la figure 3 illustre le principe de la démodulation dans le cas d'un fonctionnement en amplificateur ;
- la figure 4 illustre le principe de la démodulation dans le cas d'un fonctionnement en oscillateur ;
- la figure 5 montre quelques exemples de réalisation d'un déphaseur ;
- la figure 6 montre un détail de réalisation de l'empilement de couches ;
- la figure 7 illustre une liaison bidirectionnelle utilisant un émetteur-récepteur conforme à l'invention ;
- la figure 8 montre une application de l'invention à la réalisation d'un répéteur.

### Exposé détaillé de modes de réalisation

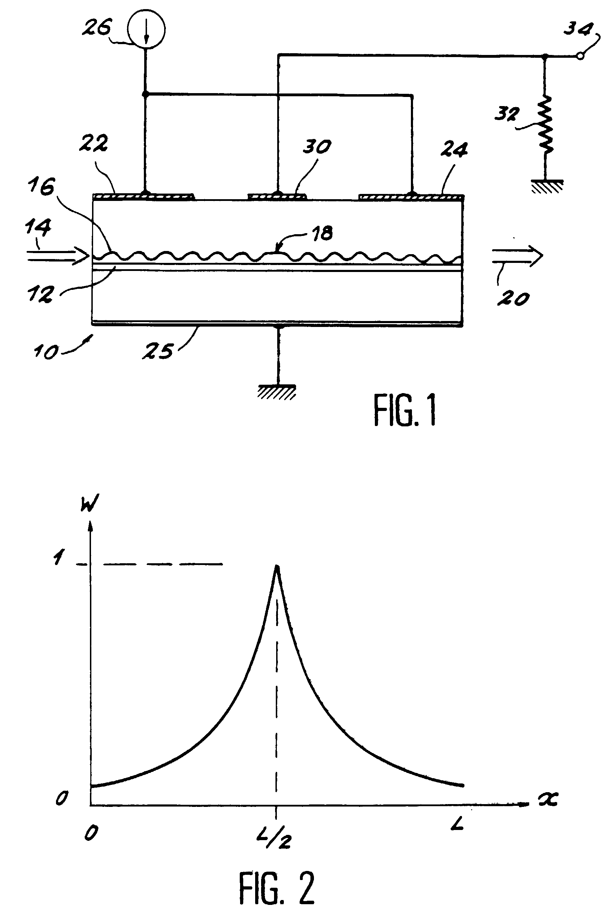

Le photorécepteur représenté sur la figure 1 comprend une structure semiconductrice 10 à contre-réaction distribuée (DFB) composée d'un empilement de couches dont une couche active 12 recevant un faisceau optique 14 et un réseau de diffraction 16 optiquement couplé à au moins une partie de la couche active 12. Ce réseau 16 comporte une région centrale 18 introduisant un déphasage optique.

Les moyens pour prélever la tension aux bornes de cette structure sont constitués par une électrode centrale 30 disposée au-dessus de la région centrale 18 du réseau introduisant un déphasage optique. L'électrode d'alimentation est alors divisée en deux demi-électrodes latérales 22, 24 disposées de part et d'autre de l'électrode centrale 30 et électriquement isolées de celle-ci. Une électrode 25 est en outre disposée sous la structure et reliée par exemple à la masse.

L'électrode de prélèvement 30 est reliée à une résistance 32. Le plot de sortie 34 constitue la sortie du photorécepteur.

La structure semiconductrice est alimentée en courant par les deux demi-électrodes 22 et 24, lesquelles sont reliées en parallèle à une source de courant 26. Mais on pourrait éventuellement alimenter séparément ces deux électrodes.

Dans un laser DFB à déphasage, la puissance optique a tendance à se concentrer dans le centre de la structure comme illustré sur la figure 2. Sur cette figure, on voit la puissance optique W (en unités arbitraires) en fonction de la distance x le long de la couche active. La cavité laser est supposée avoir une longueur L. Un maximum très marqué se présente dans la zone centrale d'abscisse L/2.

La figure 2 correspond à un coefficient KL d'environ 4 où K est le coefficient de couplage du réseau avec la couche active et L la longueur de la cavité laser.

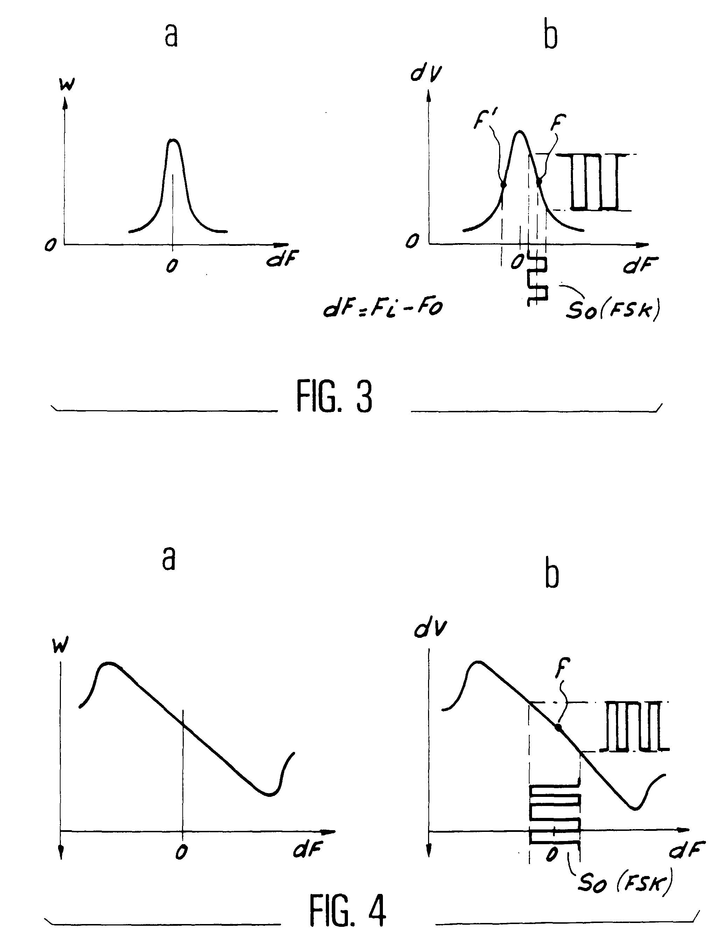

Les figures 3 et 4 illustrent le fonctionnement du photorécepteur de l'invention respectivement dans les régimes amplificateur et oscillateur. Sur ces figures, la partie (a) montre la variation de la puissance optique dans la structure semiconductrice en fonction de l'écart de fréquence dF entre la fréquence du faisceau optique incident et la fréquence propre de la structure semiconductrice. La partie (b) montre la variation de tension dV prélevée sur l'électrode centrale 30 lorsqu'un signal optique modulé en FSK est introduit dans la couche active. Ce signal optique, référencé SO(FSK) est supposé présenter une suite de deux fréquences discrètes autour d'une fréquence moyenne. Cette fréquence moyenne correspond à un décalage en fréquence dF qui se situe soit sur l'un des flancs sensiblement linéaires de la courbe dV(dF) pour un fonctionnement en amplificateur, soit à un décalage en fréquence nul pour un fonctionnement en oscillateur. Ce point de fonctionnement est référencé f sur la figure 4b et f et f' sur la figure 3b.

Les différences de fonctionnement entre les deux régimes, avec une courbe en cloche pour le régime amplificateur et une couche en Z pour le régime oscillateur, ont déjà été soulignées dans le document FR-A-2 652 465 déjà cité auquel on pourra se reporter.

On observera que, dans l'invention, la différence de fréquence Fi-Fo entre la fréquence du rayonnement incident et la fréquence propre du laser, est inférieure à la largeur de la bande dans laquelle le verrouillage ("locking") se produit.

L'une des caractéristiques essentielles de l'invention est donc la présence, au-dessus du déphaseur, d'une électrode de prélèvement de tension. Quant à ce déphaseur, il peut être de tout type connu. De nombreux exemples de réalisation ont été décrits dans la littérature, notamment dans les articles suivants :
- K. Sekartedjo, N. Eda, K. Furuya, Y. Suematsu, F. Koyama et T. Tanbun-Ek, "1.5 µm phase-shifted DFB lasers for single-mode operation", Electron. Lett., 20, pp. 80-81, (1984),
- M. Gilleron, J. Charil, D. Lesterlin, P. Correc et J.C. Bouley, "1.5 µm phase shifted distributed feedback laser", J. Physique, Colloque C4, supplément au n°9, tome 49, sept. 1988,
- T. Matsuyama, A. Makuta, A. Tanaka, K. Ohtsuka, H. Agatsuma et J. Kinoshita, "TM mode suppresion property of DFB lasers with a narrow stripe région", IEEE Photonics Techn. Lett. 2, pp. 612-613, (1990).

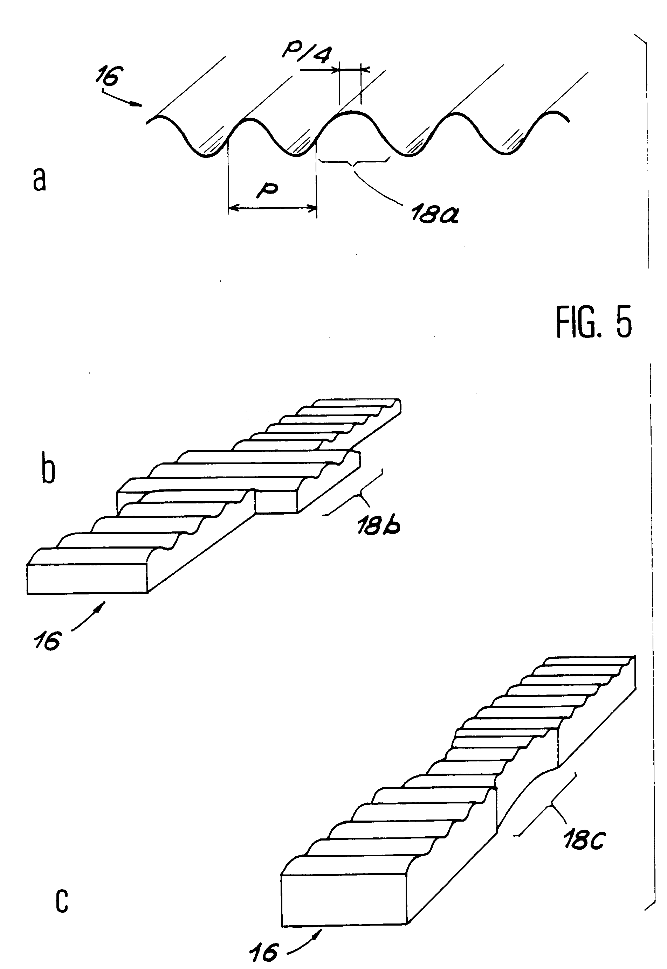

Trois exemples de déphaseurs sont illustrés sur la figure 5, mais il va de soi que ces exemples ne limitent en rien la portée de l'invention.

Sur la partie a, on voit, schématiquement représenté, un réseau de diffraction 16 avec sa surface présentant une ondulation périodique de pas p. Dans la zone centrale 18a, ce pas est allongé d'un quart de pas (p/4) ce qui introduit un déphasage optique d'un quart de longueur d'onde pour une onde cheminant le long du réseau, dans un sens ou dans l'autre. Naturellement, on pourrait aussi raccourcir le réseau d'un quart de pas.

Sur la partie b, on voit un réseau 16 au pas régulier mais présentant, dans la zone centrale 18b, une partie élargie. La longueur de la zone élargie correspond à un déphasage optique d'un quart de longueur d'onde.

Sur la partie c, au contraire, le réseau présente une zone 18c rétrécie.

Tous ces déphaseurs peuvent être utilisés dans l'invention.

Pour réaliser la structure de l'invention, tout procédé connu convient. On peut, par exemple, utiliser une technique dite du ruban enterré (Buried Ridge Stripe). Une telle technique est décrite dans l'article de J. Charil, S. Slempkes, D. Robein, C. Kazmierski et J.C. Bouley, "Extremely low threshold operation of 1.5 µm GaInAsP/InP buried ridge stripe lasers", Electron. Lett., 25, pp. 1477-1479, (1989).

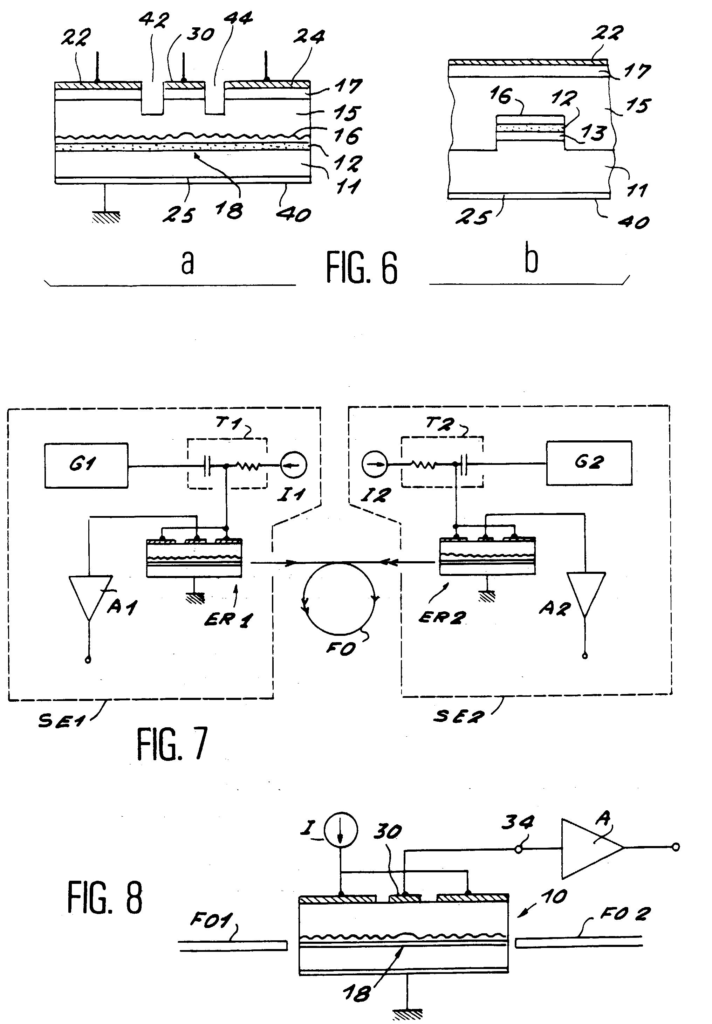

Ce mode de réalisation, qui n'est en rien limitatif de l'invention, est illustré sur la figure 6, en coupe longitudunale (a) et en coupe transversale (b). On y retrouve des éléments déjà représentés sur la figure 1 et qui portent les mêmes références, à savoir, la couche active 12, le réseau 16, les électrodes latérales 22 et 24, l'électrode inférieure 25, l'électrode centrale 30. On voit, en outre, que les électrodes 22, 24, d'une part, et 30, d'autre part, sont séparées par deux coupures 42 et 44 obtenues par gravure. Par ailleurs, on voit sur la partie (b) que la couche active 12 est située dans un ruban enterré dans une couche 15. La couche active 12 peut reposer sur une couche de confinement 13, elle-même reposant sur un substrat 11. Enfin, une couche semiconductrice très dopée 17 est intercalée entre les électrodes supérieures 22, 24, 30 et la couche 15.

A titre d'exemple, la couche active 12 peut être réalisée au moyen d'un empilement de couches constituant une structure à multipuits quantiques ("Multiple Quantum Wells" ou MQW) centrée sur la longueur d'onde de 1,5 µm. Le substrat 11 peut être en InP dopé N, la couche de confinement 13 peut être centrée sur une longueur d'onde de 1,3 µm ainsi que la couche 15, le tout en InP dopé P. La couche 17 peut être en InP dopé P⁺.

La présente invention a également pour objet une liaison optique bidirectionnelle. Cette liaison représentée sur la figure 7. Elle comporte un premier sous-ensemble SE1, une fibre optique F0 et un second sous-ensemble SE2. Ces deux sous-ensembles sont identiques et comprennent les mêmes moyens référencés par une lettre affectée d'un indice 1 pour le premier d'un indice et 2 pour le second. Le premier sous-ensemble SE1 comprend ainsi un émetteur-récepteur ER1 conforme à celui de la figure 1, un amplificateur haute fréquence A1 relié à l'électrode centrale de prélèvement de la tension, cet amplificateur délivrant un signal de démodulation, une source de courant I1 reliée aux électrodes latérales d'alimentation à travers un Té de polarisation T1 constitué par un condensateur et une inductance et enfin un générateur G1 d'informations apte à moduler le courant du laser pour moduler sa fréquence d'émission. L'intensité du courant délivré par I1 est réglée selon le mode de fonctionnement choisi, soit au voisinage du seuil (amplificateur) soit très au-dessus du seuil (oscillateur).

Enfin, la figure 8 montre que la structure de l'invention peut encore fonctionner en répéteur avec les mêmes moyens. Sur cette figure, la structure 10 reçoit un faisceau lumineux issus d'une première fibre optique F01 et délivre un faisceau amplifié guidé par une seconde fibre optique F02. Grâce à sa zone 18 à déphasage et à son électrode de prélèvement de tension 30, la structure délivre une tension de contrôle éventuellement amplifiée par un amplificateur A. On peut ainsi contrôler en permanence la qualité du signal amplifié.

## Revendications

1. Photorécepteur pour signaux optiques modulés en fréquence, comprenant une structure semiconductrice (10) à contre-réaction distribuée (DFB) composée d'un emilement de couches dont une couche active (12) et un réseau de diffraction (16) optiquement couplé à au moins une partie de la couche active (12), ce réseau (16) comportant une région centrale (18) introduisant un déphasage optique, cette structure étant recouverte d'une électrode (22, 24) reliée à une source de courant (26), ce photorécepteur comprenant en outre des moyens pour prélever la tension aux bornes de la structure, ce photorécepteur étant caractérisé par le fait que les moyens pour prélever la tension aux bornes de la structure sont constitués par une électrode centrale (30) disposée au-dessus de la région centrale (18) du réseau introduisant un déphasage optique, l'électrode d'alimentation étant alors divisée en deux demi-électrodes latérales (22, 24) disposées de part et d'autre de l'électrode centrale (30) et électriquement isolées de celle-ci.

2. Photorécepteur selon la revendication 1, caractérisé par le fait que la région centrale (18) du réseau (16) introduisant un déphasage est une zone où le pas du réseau est localement diminué ou allongé (18a), ou une zone où la largeur du réseau est augmentée (18b) ou diminuée (18c), le pas restant constant.

3. Photorécepteur selon la revendication 1, caractérisé par le fait que la couche active (12) est une couche semiconductrice massive ou à multipuits quantiques.

4. Emetteur-récepteur, caractérisé par le fait qu'il est constitué par le photorécepteur selon l'une quelconque des revendications 1 à 3, cet émetteur-récepteur se comportant comme un laser ayant une fréquence propre Fo et une fréquence de fonctionnement qui se cale sur la fréquence Fi du signal optique incident, la différence Fi-Fo entre la fréquence Fi du signal optique reçu et la fréquence propre Fo étant tenue inférieure à une largeur correspondant à une bande de verrouillage en fréquence du laser.

5. Liaison optique bidirectionnelle comprenant un premier ensemble émetteur-récepteur (SE1), une ligne de transmission optique (F0) et un second ensemble émetteur-récepteur (SE2), caractérisée par le fait que le premier et second ensembles émetteurs-récepteurs (SE1, SE2) comprennent l'émetteur-récepteur de la revendication 4.

## Claims

1. Photoreceiver for frequency-modulated optical signals, comprising a distributed feedback (DFB) semiconductor structure (10) constituted by a stack of layers, including an active layer (12) and a diffraction grating (16) optically coupled to at least part of said active layer (12), said grating (16) having a central region (18) introducing an optical phase shift, said structure being covered by an electrode (22, 24) connected to a power supply (26), said photoreceiver also comprising means for tapping the voltage at the terminals of the structure, said photoreceiver being characterized in that the means for tapping the voltage at the terminals of the structure are constituted by a centre electrode (30) positioned above the central region (18) of the grating introducing an optical phase shift, the supply electrode then being subdivided into two lateral half-electrodes (22, 24) positioned on either side of the centre electrode (30) and electrically insulated therefrom.

2. Photoreceiver according to claim 1, characterized in that the central region (18) of the grating (16) introducing a phase shift is en area where the spacing of the grating is locally decreased or increased (l8a) , or an area where the width of the grating is increased (18b) or decreased (18c), the spacing remaining constant.

3. Photoreceiver according to claim 1, characterized in that the active layer (12) is a solid or multiple quantum well semiconductor layer.

4. Transmitter - receiver, characterized in that it is constituted by the photoreceiver according to any one of the claims 1 to 3, said transmitter-receiver behaving like a laser having a natural frequency Fo and an operating frequency tuned to the frequency Fi of the incident optical signal, the difference Fi-Fo between the frequency Fi of the optical signal received and the natural frequency Fo being kept below a width corresponding to a frequency locking band of the laser.

5. Bidirectional optical link incorporating a first transmitter - receiver assembly (SET), an optical transmission line (FO) and a second transmitter - receiver assembly (SE2), characterized in that the first and second transmitter - receiver assemblies (SE1, SE2) comprise the transmitter-receiver of claim 4.

## Patentansprüche

1. Photoempfänger für frequenzmodulierte optische Signale, eine Halbleiterstruktur (10) mit verteilter Rückkopplung (DFB oder Distributed Feedback) umfassend, gebildet durch einen Stapel von Schichten, darunter eine aktive Schicht (12) und ein optisch mit wenigstens einem Teil der aktiven Schicht (12) gekoppeltes Beugungsgitter (16), wobei dieses Gitter (16) einen zentralen Bereich (18) umfaßt, der eine optische Phasenverschiebung einführt, wobei diese Struktur von einer Elektrode (22, 24) bedeckt ist, verbunden mit einer Stromquelle (26), dieser Photoempfänger außerdem Einrichtungen umfaßt, um die Spannung an den Anschlüssen der Struktur abzugreifen, und dieser Photoempfänger dabei
**dadurch gekennzeichnet** ist,
daß die Einrichtungen zum Abgreifen der Spannung an den Anschlüssen der Struktur durch eine zentrale Elektrode (30) gebildet werden, angeordnet über dem zentralen Bereich (18) des eine optische Phasenverschiebung einführenden Gitters, und die Versorgungselektrode dann in zwei seitliche Halbelektroden (22, 24) geteilt ist, die beiderseits der zentralen Elektrode (30) angeordnet und elektrisch von dieser isoliert sind.

2. Photoempfänger nach Anspruch 1, dadurch gekennzeichnet, daß der zentrale Bereich (18) des eine Phasenverschiebung einführenden Gitters (16) eine Zone ist, wo die Gitterteilung lokal verkürzt oder verlängert ist (18a), oder eine Zone, wo die Breite des Gitters vergrößert (18b) oder verkleinert (18c) ist, wobei die Teilung konstant bleibt.

3. Photoempfänger nach Anspruch 1, dadurch gekennzeichnet, daß die aktive Schicht (12) eine massive Schicht oder eine mit Multi-Potential- bzw. -Quantentöpfen ist.

4. Empfänger-Sender, dadurch gekennzeichnet, daß er durch den Photoempfänger nach einem der Ansprüche 1 bis 3 gebildet wird, wobei dieser Empfänger-Sender sich wie ein Laser verhält, der eine Eigenfrequenz Fo aufweist und eine Betriebsfrequenz, die sich einstellt auf die Frequenz Fi des eintreffenden optischen Signals, wobei die Differenz Fi-Fo zwischen der Frequenz Fi des empfangenen optischen Signals und der Eigenfrequenz Fo innerhalb einer Breite gehalten wird, die einem Frequenzverriegelungsband des Lasers entspricht.

5. Optische Zweirichtungsverbindung, eine erste Empfänger-Sender-Einheit (SE1), eine optische Übertragungsleitung (FO) und eine zweite Empfänger-Sender-Einheit (SE2) umfassend, dadurch gekennzeichnet, daß die erste und die zweite Empfänger-Sender-Einheit (SE1, SE2) den Empfänger-Sender des Anspruchs 4 umfassen.
